# EUROPEAN PATENT APPLICATION

(11) **EP 2 500 928 A1**
(43) Date of publication of application: **19.09.2012**
(21) Application number: 10829776.3
(22) Date of filing: 14.09.2010
(51) Int. Cl.: H01L 21/304, B24B 37/00, C09K 3/14

(54) **CHEMICAL-MECHANICAL POLISHING LIQUID, AND SEMICONDUCTOR SUBSTRATE MANUFACTURING METHOD AND POLISHING METHOD USING SAID POLISHING LIQUID**

(30) Priority: 12.11.2009 JP 2009259264
(71) Applicant: Hitachi Chemical Company, Ltd., Tokyo 163-0449 (JP)
(72) Inventor: YOSHIKAWA, Shigeru, Hitachi-shi Ibaraki 317-8555 (JP); AKUTSU, Toshiaki, Hitachi-shi Ibaraki 317-8555 (JP); FUKASAWA, Masato, Hitachi-shi Ibaraki 317-8555 (JP)
(74) Representative: HOFFMANN EITLE
(86) International application number: PCT/JP2010/065863
(87) International publication number: WO 2011/058816

(57) **Abstract**

The first embodiment of the CMP polishing liquid of the invention comprises cerium oxide particles, an organic compound with an acetylene bond, and water, the content of the organic compound with an acetylene bond being at least 0.00001 mass% and not greater than 0.01 mass% based on the total mass of the CMP polishing liquid. The second embodiment of the CMP polishing liquid of the invention comprises cerium oxide particles, an organic compound with an acetylene bond, an anionic polymer compound or salt thereof, and water, the anionic polymer compound being obtained by polymerizing a composition comprising a vinyl compound with an anionic substituent as a monomer component, the content of the organic compound with an acetylene bond being at least 0.000001 mass% and less than 0.05 mass% based on the total mass of the CMP polishing liquid.

## Description

### Technical Field

The present invention relates to a CMP polishing liquid, and to a polishing method and semiconductor substrate manufacturing method using the same. In particular, the invention relates to a CMP polishing liquid to be used in a base substrate surface flattening step, such as an interlayer dielectric film flattening step or STI (Shallow Trench Isolation) forming step, in a technique for manufacturing of electronic components such as semiconductor elements, as well as to a polishing method and a semiconductor substrate manufacturing method using the same.

### Background Art

There is a trend toward increasing packaging density in ultralarge-scale integrated circuits of semiconductor devices, and various micromachining techniques are being researched and developed. Design rules have already reached the sub-half-micron order. CMP (chemical mechanical polishing) is a technique that meets this intense demand for micronization. CMP technology achieves flattening the surfaces of layers that are to be exposed in production steps for electronic components such as semiconductor devices, and reduces the engineering load in the exposure step, and allows yields to be stabilized. CMP technology is therefore indispensable for flattening of interlayer dielectric films and formation of STI, for example.

In conventional semiconductor device manufacturing steps, research has been conducted on the use of silica-based CMP polishing liquids containing fumed silica, as CMP polishing liquids used for flattening of inorganic insulating films such as silicon oxide films formed by methods such as plasma-CVD (Chemical Vapor Deposition) and low pressure-CVD. Silica-based CMP polishing liquids are produced by conducting grain growth of silica particles by methods such as thermal decomposition to silicon tetrachloride, and adjusting the pH. One technical problem with such CMP polishing liquids, however, is that the polishing rate is reduced for inorganic insulating films that are films to be polished.

On the other hand, CMP polishing liquids comprising cerium oxide particles are used as CMP polishing liquids for surface of glasses such as photomasks or lenses. Cerium oxide particles have lower hardness than silica particles or alumina particles, and therefore create fewer scratches in surfaces to be polished when used for polishing. Cerium oxide particles are therefore useful for mirror-polishing for finishing. In addition, CMP polishing liquids containing cerium oxide particles have the advantage of superior polishing rate compared to CMP polishing liquids containing silica particles. In recent years, CMP polishing liquids for semiconductor using high-purity cerium oxide particles have also become known (see Patent document 1, for example).

Cerium oxide particles have higher density than silica particles and are thus more prone to sedimentation, and lower the polishing rate in some cases. There are also known, therefore, CMP polishing liquids that improve the dispersibility of cerium oxide particles by using an appropriate dispersing agent, from the viewpoint of increasing the polishing rate (see Patent document 2, for example).

There is also known addition of additives to CMP polishing liquids containing cerium oxide particles, to control the polishing rate and increase the global flatness (see Patent document 3, for example). From the viewpoint of increasing flatness, there is known addition of organic compounds with acetylene bonds to CMP polishing liquids (see Patent document 4, for example).

### Citation List

### Patent Literature

[Patent document 1] Japanese Unexamined Patent Application Publication HEI No. 10-106994
[Patent document 2] Japanese Unexamined Patent Application Publication HEI No. 10-152673
[Patent document 3] Japanese Unexamined Patent Application Publication HEI No. 8-22970
[Patent document 4] Japanese Unexamined Patent Application Publication No. 2008-85058

### Summary of Invention

### Technical Problem

In recent years, incidentally, with the trend toward even higher packaging density of integrated circuits, further advances continue to be made in micronization of trench widths of substrates subjected to STI steps, for example. With such increasing micronization levels, scratches produced on semiconductor substrate surfaces are having greater influence on reliability and yield of semiconductor substrate. Thus, while CMP polishing liquids containing cerium oxide particles have the advantage of low scratches compared to CMP polishing liquids containing silica particles, the conventional level of reduction in scratches is insufficient, and the demand for reduced scratches is becoming even more stringent.

Methods for reducing scratches with CMP polishing liquids containing cerium oxide particles have been studied, including methods of removing impurities in the cerium oxide particles, methods of micronizing the particle sizes of the cerium oxide particles, and methods of removing large particles. Such methods, however, cause inconveniences such as reduced flatness of the surface to be polished or reduced polishing rate, and it has often been difficult to achieve both minimizing formation of scratches and obtaining other properties. In particular, because reduced polishing rate causes lower throughput, it is desirable to achieve both inhibiting reduction in polishing rate and minimizing formation of scratches.

The present invention has been accomplished with the aim of solving the problems described above, and its object is to provide a CMP polishing liquid that can both inhibit reduction in polishing rate and minimize formation of scratches, as well as a polishing method and a semiconductor substrate manufacturing method that employ the same.

### Solution to Problem

As a result of diligent research, the present inventors have found that, for a CMP polishing liquid employing cerium oxide particles as the abrasive grains, adding a trace amount of an organic compound with an acetylene bond to the CMP polishing liquid comprising the cerium oxide particles can inhibit reduction in the polishing rate and can minimize formation of scratches.

Specifically, the first embodiment of the CMP polishing liquid of the invention comprises cerium oxide particles, an organic compound with an acetylene bond, and water, the content of the organic compound with an acetylene bond being at least 0.00001 mass% (0.1 ppm) and not greater than 0.01 mass% (100 ppm) based on the total mass of the CMP polishing liquid.

According to the first embodiment of the CMP polishing liquid, the CMP polishing liquid comprises a trace amount of an organic compound with an acetylene bond at the content specified above, to allow reduction in polishing rate to be inhibited and formation of scratches to be minimized. Also, according to the first embodiment of the CMP polishing liquid, it is possible to facilitate a flatness-improving effect (an effect of preferential polishing of convexities) for polishing of surface to be polished with few irregularities, or polishing of surface for rough polishing.

Incidentally, Patent document 4 teaches that the flatness of polished surfaces after polishing can be improved by adding an organic compound with an acetylene bond. However, the present inventors conjecture that the effect of the present invention and the effect of Patent document 4 technique during polishing fundamentally differ, based on the difference in the contents of the organic compound with an acetylene bond.

Specifically, while the content of the organic compound with an acetylene bond is high with the CMP polishing liquid of Patent document 4, the content of the organic compound with an acetylene bond is only a trace amount (on the order of ppm) with the first embodiment of the CMP polishing liquid of the invention. Thus, while there is a limit to achieve high levels for both the effect of increasing polishing rate by the organic compound with an acetylene bond and the effect of minimizing scratches, with the CMP polishing liquid of Patent document 4, it is possible to achieve high levels for both the effect of increasing polishing rate and the effect of minimizing scratches with the first embodiment of the CMP polishing liquid of the invention.

In addition, the CMP polishing liquid according to the first embodiment may be obtained by mixing a first liquid comprising cerium oxide particles and water, and a second liquid comprising an organic compound with an acetylene bond and water.

The present inventors have further found that it is also possible to inhibit reduction in polishing rate and to minimize formation of scratches by adding a trace amount of an organic compound with an acetylene bond, as well as adding a prescribed anionic polymer compound or salt thereof, to a CMP polishing liquid comprising cerium oxide particles.

Specifically, the CMP polishing liquid according to the second embodiment of the invention comprises cerium oxide particles, an organic compound with an acetylene bond, an anionic polymer compound or salt thereof, and water, the anionic polymer compound being obtained by polymerizing a composition comprising a vinyl compound with an anionic substituent as a monomer component, the content of the organic compound with an acetylene bond being at least 0.000001 mass% (0.01 ppm) and less than 0.05 mass% (500 ppm) based on the total mass of the CMP polishing liquid.

According to the second embodiment of the CMP polishing liquid, the CMP polishing liquid comprises a trace amount of an organic compound with an acetylene bond at the content specified above, and also comprises a prescribed anionic polymer compound or salt thereof, to allow reduction in polishing rate to be inhibited and scratches to be minimized. The second embodiment of the CMP polishing liquid also allows polishing surfaces to be polished with numerous irregularities to a satisfactory degree of flatness.

The CMP polishing liquid according to the second embodiment may be obtained by mixing a third liquid comprising cerium oxide particles and water, and a fourth liquid comprising an organic compound with an acetylene bond, an anionic polymer compound or salt thereof, and water.

The vinyl compound with an anionic substituent is preferably at least one type selected from acrylic acid and methacrylic acid. This will allow reduction in the polishing rate to be inhibited, while further minimizing formation of scratches.

The content of the anionic polymer compound or salt thereof is preferably greater than the content of the organic compound with an acetylene bond. This will allow reduction in the polishing rate to be inhibited, while further minimizing formation of scratches.

The content of the anionic polymer compound or salt thereof is preferably 0.01-2.00 mass% based on the total mass of the CMP polishing liquid. This will allow reduction in the polishing rate to be inhibited, while further minimizing formation of scratches.

In the first and second embodiments of the CMP polishing liquid, the organic compound with an acetylene bond is preferably an acetylene glycol. The acetylene glycol is more preferably a compound represented by the following formula (1), and even more preferably 2,4,7,9-tetramethyl-5-decyne-4,7-diol. This will allow formation of scratches to be further minimized. 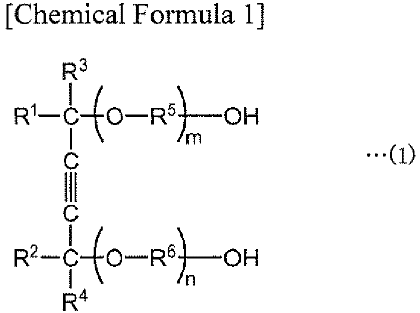 (In formula (1), R¹-R⁴ each independently represents a hydrogen atom or a C1-C5 substituted or unsubstituted alkyl group, R⁵ and R⁶ each independently represents a C1-C5 substituted or unsubstituted alkylene group, and m and n each independently represents 0 or an integer.)

The polishing method of the invention comprises a step of polishing a film to be polished, that has been formed on a base substrate, using the aforementioned CMP polishing liquid.

In the polishing method of the invention, since the aforementioned CMP polishing liquid is used, it can inhibit reduction in polishing rate and minimize formation of scratches.

The semiconductor substrate manufacturing method of the invention comprises a step of polishing an inorganic insulating film that has been formed on a semiconductor substrate, using the aforementioned CMP polishing liquid.

In the semiconductor substrate manufacturing method of the invention, since the aforementioned CMP polishing liquid is used, it can inhibit reduction in polishing rate and minimize formation of scratches.

### Advantageous Effects of Invention

According to the invention it is possible to provide a CMP polishing liquid that can both inhibit reduction in polishing rate and minimize formation of scratches, as well as a polishing method and a semiconductor substrate manufacturing method that employ the same.

### Brief Description of Drawings

Fig. 1 is a schematic cross-sectional view illustrating a process in which a silicon oxide film is polished to form an STI structure on a semiconductor substrate.
Fig. 2 is a view showing the relationship of additive concentration to polishing rate and number of scratches.

### Description of Embodiments

Preferred embodiments of the invention will now be explained in detail, with reference to the accompanying drawings as necessary.

The CMP polishing liquid of the first embodiment comprises cerium oxide particles, an organic compound with an acetylene bond (hereunder referred to as "acetylene compound"), and water. The CMP polishing liquid of the second embodiment comprises cerium oxide particles, an acetylene compound, an anionic polymer compound obtained by polymerizing a composition comprising a vinyl compound with an anionic substituent as a monomer component, or a salt thereof, and water. The components in the CMP polishing liquid will now be described.

### (Cerium oxide particles)

The cerium oxide particles may be any ones that are in particulate form. The method for producing the cerium oxide particles is not particularly restricted, and any conventionally known cerium oxide particles may generally be used for most purposes.

Examples for the method for producing the cerium oxide particles include firing, and oxidation with hydrogen peroxide or the like. When the cerium oxide particles are to be obtained by firing, a cerium compound is preferably fired at 350-900°C for 1 hour or longer in a firing step to obtain fired powder. The firing temperature is more preferably 500-900°C and even more preferably 600-900°C. The upper limit for the firing time may be about 3 hours.

The half-width of the diffraction peak for the (111) plane of the cerium oxide crystals, in powder X-ray diffraction pattern of the fired powder using CuKα-rays as the line source, is preferably 0.20-0.50° and more preferably 0.20-0.40°. This will allow cerium oxide particles having a suitable degree of crystallization and a suitable crystallite (minimum crystal unit) size to be obtained. The half-width of the diffraction peak can be appropriately adjusted by the firing temperature and firing time for the firing step.

When the produced cerium oxide particles have aggregated, the aggregated particles are preferably subjected to mechanical grinding in a grinding step. The grinding method is preferably, for example, dry grinding with a jet mill or wet grinding using a planetary bead mill or the like. The jet mill used may be, for example, the one in the method described in "Kagaku Kougaku Ronbunshu", Vol.6, No.5 (1980), p.527-532.

The cerium oxide particles used as the abrasive grains preferably include polycrystalline cerium oxide particles having grain boundaries. In the grinding step, the fired powder is preferably ground so as to form polycrystalline cerium oxide particles composed of multiple crystallites and having grain boundaries. Because such polycrystalline cerium oxide particles having grain boundaries successively present new surfaces (active surfaces) as they are broken during polishing, which have not contacted the medium before being broken, it is possible to highly maintain a high polishing rate for silicon oxide films. Such cerium oxide particles are described in WO99/31195 (National Publication of Translated Version), for example.

There are no particular restrictions on the mean particle size of the cerium oxide particles, but generally a smaller mean particle size tends to lower the polishing rate while a larger mean particle size tends to result in more scratches. From the viewpoint of further increasing the polishing rate, the mean particle size is preferably 0.05 µm or greater and more preferably 0.07 µm or greater. From the viewpoint of further minimizing formation of scratches, the mean particle size is preferably not greater than 1.00 µm and more preferably not greater than 0.40 µm.

The mean particle size of the cerium oxide particles is the mean value for the volume distribution, measured with a laser diffraction scattering particle size distribution meter, using a liquid containing the cerium oxide particles for measuring object. The measuring object is the final CMP polishing liquid when the CMP polishing liquid is to be stored as an one-pack liquid, or it is a slurry comprising the cerium oxide particles before mixture, when it is to be stored as a two-pack liquid.

The mean particle size of the cerium oxide particles can be measured, specifically, by diluting the CMP polishing liquid or slurry for measuring object to obtain the measuring sample having suitable concentration for measurement, and loading the measuring sample into a laser diffraction scattering particle size distribution meter. More specifically, the mean particle size of the cerium oxide particles can be measured in the following manner, using an LA-920 by Horiba, Ltd. (light sources: He-Ne laser and W laser). First, the CMP polishing liquid or slurry for measuring object is diluted to obtain the measuring sample having suitable concentration for measurement such that a transmittance (H) with a He-Ne laser during measurement is adjusted to of 60-70%. The measuring sample is then loaded into the LA-920 and the arithmetic mean diameter (mean size) is recorded as the mean particle size.

The content of cerium oxide particles in the CMP polishing liquid is not particularly restricted, but the lower limit for the cerium oxide particle content is preferably 0.10 mass% or greater, more preferably 0.20 mass% or greater and even more preferably 0.30 mass% or greater based on the total mass of the CMP polishing liquid, from the viewpoint of obtaining a more satisfactory polishing rate. From the viewpoint of increasing the dispersibility of the particles and further minimizing scratches, the upper limit for the cerium oxide particle content is preferably not greater than 20 mass%, more preferably not greater than 10 mass% and even more preferably not greater than 5 mass% based on the total mass of the CMP polishing liquid.

### (First additive: Acetylene compound)

Examples of acetylene compounds include one or more selected from among alkynes, acetylene alcohols and acetylene glycols. Alkynes include 1-decyne, 5-decyne and the like. Acetylene alcohols include 3,5-dimethyl-1-hexyn-3-ol and 2,4-dimethyl-5-hexyn-3-ol and the like. Acetylene glycols include compounds represented by the following formula (1), and the like. These acetylene compounds may be used alone or in combinations of two or more. 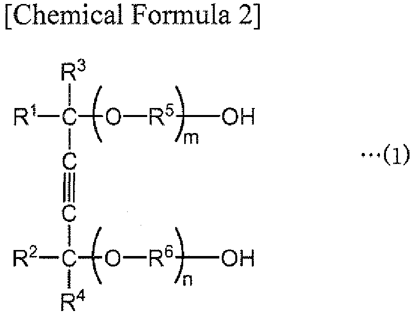 (In formula (1), R¹-R⁴ each independently represents a hydrogen atom or a C1-C5 substituted or unsubstituted alkyl group, R⁵ and R⁶ each independently represents a C1-C5 substituted or unsubstituted alkylene group, and m and n each independently represents 0 or an integer.)

As acetylene compounds there are preferred acetylene glycols, from the viewpoint of more easily obtaining an effect of minimizing scratches, and more preferably compounds represented by formula (1), even more preferably compounds of formula (1) wherein m and n are 0, especially preferably 2,4,7,9-tetramethyl-5-decyne-4,7-diol, 3,6-dimethyl-4-octyn-3,6-diol and, from the viewpoint of ready availability and an excellent effect of minimizing scratches, extremely preferably 2,4,7,9-tetramethyl-5-decyne-4,7-diol.

In the CMP polishing liquid of the first embodiment, the lower limit for the first additive content is at least 0.00001 mass% (0.1 ppm) based on the total mass of the CMP polishing liquid, and from the viewpoint of more efficiently obtaining an effect of minimizing scratches, it is preferably at least 0.00002 mass% (0.2 ppm), more preferably at least 0.00003 mass% (0.3 ppm) and even more preferably at least 0.00005 mass% (0.5 ppm). The upper limit for the first additive content is not greater than 0.01 mass% (100 ppm) based on the total mass of the CMP polishing liquid, and from the viewpoint of more efficiently obtaining an effect of minimizing scratches, it is preferably not greater than 0.008 mass% (80 ppm) and even more preferably not greater than 0.005 mass% (50 ppm). If the content of the first additive in the CMP polishing liquid of the first embodiment is 0.00001 mass% or greater, the number of scratches will be drastically reduced compared to absolutely no addition of the first additive (content: 0 mass%). If the content of the first additive in the CMP polishing liquid of the first embodiment is not greater than 0.01 mass%, it will be easier to obtain an effect of minimizing scratches. The content of the first additive is preferably 0.00001-10 parts by mass with respect to 100 parts by mass of the cerium oxide particles.

In the CMP polishing liquid of the second embodiment, the lower limit for the first additive content is at least 0.000001 mass% (0.01 ppm) based on the total mass of the CMP polishing liquid, and from the viewpoint of more efficiently obtaining an effect of minimizing scratches, it is preferably at least 0.000003 mass% (0.03 ppm), more preferably at least 0.000005 mass% (0.05 ppm), even more preferably at least 0.00001 mass% (0.1 ppm), and especially preferably at least 0.00005 mass% (0.5 ppm). The upper limit for the first additive content is less than 0.05 mass% (500 ppm) based on the total mass of the CMP polishing liquid, and from the viewpoint of more efficiently obtaining an effect of minimizing scratches, it is preferably not greater than 0.03 mass% (300 ppm), more preferably not greater than 0.02 mass% (200 ppm) and even more preferably not greater than 0.01 mass% (100 ppm). If the content of the first additive in the CMP polishing liquid of the second embodiment is 0.000001 mass% or greater, the number of scratches will be drastically reduced compared to absolutely no addition of the first additive (content: 0 mass%). If the content of the first additive in the CMP polishing liquid of the second embodiment is less than 0.05 mass%, it will be easier to obtain an effect of minimizing scratches. The content of the first additive is preferably 0.00001-50 parts by mass with respect to 100 parts by mass of the cerium oxide particles.

### (Second additive: Anionic polymer compound or its salt)

The second additive is a suitable compound which, during polishing of a surface to be polished with irregularities, is adsorbed onto the surface to be polished and forms a protective film, inhibiting polishing at the concavities where the abrasive pad does not contact, and allowing preferential polishing of the convexities. In the CMP polishing liquid of the second embodiment, the second additive is an anionic polymer compound obtained by polymerizing a composition comprising a vinyl compound with an anionic substituent as a monomer component, or a salt thereof. The second additive tends to inhibit scratches somewhat by being adsorbed onto the surface to be polished and forming a protective film, but such an effect is not sufficient with its use alone. Using the first additive and second additive in combination in the CMP polishing liquid of the second embodiment produces a notable effect of reducing scratches.

The anionic substituent in a vinyl compound with an anionic substituent may be, for example, a carboxyl group, hydroxyl group, amino group, oxirane ring or acid anhydride. Examples of vinyl compounds with anionic substituents include acrylic acid, methacrylic acid and methyl acrylate. These vinyl compounds may be used alone or in combinations of two or more. The anionic polymer compound or salt thereof is preferably a polymer obtained by polymerizing a composition comprising at least one type selected from acrylic acid and methacrylic acid as a monomer component, or a salt thereof. Salts of anionic polymer compounds include ammonium salts, potassium salts, sodium salts and the like, with ammonium salts being preferred.

The weight-average molecular weight of the second additive is preferably 100-150000 and more preferably 1000-20000. The weight-average molecular weight of the second additive is the value measured by GPC and based on standard polystyrene, and specifically, it can be determined under the following conditions.

### (Conditions)

Sample: 10 µL
Standard polystyrene: Standard polystyrene by Tosoh Corp. (weight-average molecular weights: 190000, 17900, 9100, 2980, 578, 474, 370, 266)
Detector: RI-monitor by Hitachi, Ltd., trade name: "L-3000"
Integrator: GPC integrator by Hitachi, Ltd., trade name: "D-2200"
Pump: Trade name: "L-6000" by Hitachi, Ltd.
Degassing apparatus: Trade name "Shodex DEGAS" by Showa Denko K.K.
Column: Trade names "GL-R440", "GL-R430" and "GL-R420" by Hitachi Chemical Co., Ltd., linked in that order.
Eluent: Tetrahydrofuran (THF)
Measuring temperature: 23°C
Flow rate: 1.75 mL/min
Measuring time: 45 minutes

From the viewpoint of further improving the flattening property, the lower limit for the second additive content is preferably 0.01 mass% or greater, more preferably 0.05 mass% or greater, even more preferably 0.08 mass% or greater and especially preferably 0.10 mass% or greater, based on the total mass of the CMP polishing liquid. From the viewpoint of further increasing the polishing rate while preventing aggregation of abrasive grains, the upper limit for the second additive content is preferably not greater than 2.00 mass%, more preferably not greater than 1.00 mass% and even more preferably not greater than 0.50 mass%. The second additive content is preferably greater than the first additive content.

From the viewpoint of increasing the dispersibility and antisettling property of the abrasive grains in the CMP polishing liquid and maintaining excellent flatness, the second additive content is preferably 10-1000 parts by mass and more preferably 20-200 parts by mass with respect to 100 parts by mass of the cerium oxide particles.

### (Water)

There are no particular restrictions on the water used as the medium of the CMP polishing liquid, but deionized water, ion-exchanged water or ultrapure water is preferred. The water content in the CMP polishing liquid may be the remainder after the content of the other components, and it is not particularly restricted so long as water is present in the CMP polishing liquid. The CMP polishing liquid may further comprise a solvent other than water, if necessary, which may be a polar solvent such as ethanol, acetic acid, acetone or the like.

### (Other components)

A dispersing agent may also be added to the CMP polishing liquid, for dispersion of the cerium oxide particles in the water. The dispersing agent used may be a known dispersing agent, such as a water-soluble nonionic dispersing agent, water-soluble cationic dispersing agent or water-soluble amphoteric dispersing agent. The dispersing agent used may be the same compound as the anionic polymer compound used for the second additive, or a different compound. When an anionic polymer compound is used as the dispersing agent, the anionic polymer compound content in the total CMP polishing liquid is preferably in the aforementioned range for the second additive content, or the anionic polymer compound may be pre-mixed with the cerium oxide particles in an amount small enough so as not to affect the other components, before admixture of the other components.

The dispersing agent content is preferably 0.1-5.0 parts by mass and more preferably 0.1-2.0 parts by mass with respect to 100 parts by mass of the cerium oxide particles used as the abrasive grains. If the dispersing agent content is at least 0.1 part by mass it will be possible to improve the stability of the abrasive grains, and if it is not greater than 5.0 parts by mass it will be possible to prevent aggregation of the abrasive grains.

The weight-average molecular weight of the dispersing agent is preferably 100-150000 and more preferably 1000-20000. The weight-average molecular weight of the dispersing agent is the value measured by GPC and based on standard polystyrene.

The CMP polishing liquid may further contain materials commonly used in CMP polishing liquids, such as pH regulators or coloring agents, in addition to the components mentioned above, in ranges that do not interfere with the function and effect of the CMP polishing liquid. Such pH regulators include acid components such as nitric acid, sulfuric acid and acetic acid; alkaline components such as ammonia, potassium hydroxide and tetramethylammonium hydroxide.

### (Properties of CMP polishing liquid)

The pH of the CMP polishing liquid is preferably in the range of 3-10, from the viewpoint of improving the storage stability of the CMP polishing liquid and further minimizing formation of scratches. The pH of the CMP polishing liquid can be adjusted using a pH regulator mentioned above.

The pH of the CMP polishing liquid can be measured using a pH meter (for example, a model PHL-40 by DKK Corp.). More specifically, the pH can be measured by placing an electrode in the polishing liquid after 2-point calibration using standard buffer (phthalate pH buffer: pH 4.01 (25°C), neutral phosphate pH buffer: pH 6.86 (25°C)) and by measuring the value upon stabilization after an elapse of 2 minutes or more.

There are no particular restrictions on the viscosity of the CMP polishing liquid, but it is preferably 0.5-5 mPa· s from the viewpoint of improving the storage stability of the CMP polishing liquid. The viscosity of the CMP polishing liquid can be measured with a Ubbelohde viscometer, for example. In the case of a two-pack CMP polishing liquid, the viscosity of the cerium oxide-containing slurry is preferably 0.5-5 mPa· s from the viewpoint of obtaining excellent storage stability.

The CMP polishing liquid may be stored as a one-pack liquid comprising all of the necessary materials, or it may be stored as a two-pack liquid having the components separated into 2 liquids, with both liquids being mixed together during use to obtain the CMP polishing liquid. The CMP polishing liquid of the first embodiment is divided into 2 liquids, for example, a slurry (first liquid, hereunder referred to as "cerium oxide slurry") comprising the cerium oxide particles and water and an additive liquid (second liquid) comprising the first additive and water. The CMP polishing liquid of the second embodiment is divided into 2 liquids, for example, a slurry (third liquid, hereunder referred to as "cerium oxide slurry") comprising the cerium oxide particles and water and an additive liquid (fourth liquid) comprising the first additive, second additive and water. The dispersing agent is preferably included in the cerium oxide slurry, as necessary. The cerium oxide slurry may be stored in a concentrated state, and diluted with a diluent such as water for use during polishing. In this form, the CMP polishing liquid of the first embodiment is composed of a total of 3 liquids, a cerium oxide slurry, an additive liquid and a diluent, but throughout the present specification this form will also be referred to as a "two-pack" liquid. Also, a one-pack CMP polishing liquid may be stored in a concentrated state and diluted for use during polishing, but this form will be referred to as a "one-pack" liquid.

When the CMP polishing liquid is stored as a two-pack liquid separated into a cerium oxide slurry and an additive liquid, the composition of the two liquids may be altered as desired to modify the flattening property and polishing rate. For a two-pack liquid, there may be employed a method in which the additive liquid is conveyed through a separate tubing from the tubing for the cerium oxide slurry, and the slurry tubing and additive liquid tubing are merged just before the supply tubing outlet to mix the two liquids and obtain the CMP polishing liquid, after which the CMP polishing liquid is supplied onto the polishing platen, or a method in which the cerium oxide slurry and additive liquid are mixed just before polishing.

### (Polishing method and semiconductor substrate manufacturing method)

The polishing method of this embodiment comprises a step of polishing a film to be polished, that has been formed on a base substrate, using the CMP polishing liquid described above. The semiconductor substrate manufacturing method of this embodiment comprises a step of polishing a film to be polished, that has been formed on a semiconductor substrate, using the CMP polishing liquid described above. The film to be polished may be, for example, an inorganic insulating film, such as a silicon oxide film.

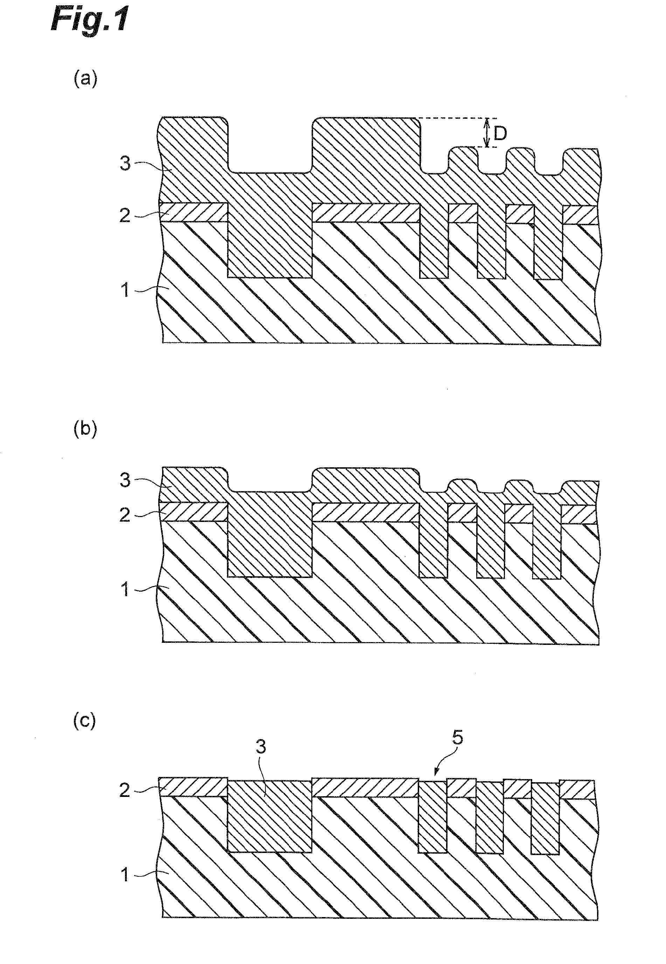

The polishing method and semiconductor substrate manufacturing method, for formation of an STI structure by using the CMP polishing liquid described above, will now be described concretely with reference to Fig. 1. The polishing method and semiconductor substrate manufacturing method, that employ a CMP polishing liquid, comprise a first step (rough polishing step) in which a film to be polished formed on a semiconductor substrate is polished at a high rate, and a second step (finishing step) in which the remaining film to be polished is polished at a relatively low rate for final flattening of the polished surface.

Fig. 1 is a schematic cross-sectional view illustrating a procedure in which a film to be polished is polished to form an STI structure on a semiconductor substrate. Fig. 1(a) is a schematic cross-sectional view showing the substrate before polishing. Fig. 1(b) is a schematic cross-sectional view showing the substrate after the first step. Fig. 1(c) is a schematic cross-sectional view showing the substrate after the second step.

As shown in Fig. 1, during the process of forming the STI structure, the partially protruding undesired sections are preferentially removed by CMP in order to eliminate step height D of the silicon oxide film (inorganic insulating film) 3 formed on the silicon substrate (semiconductor substrate) 1. In order to halt polishing at an appropriate point when the surface has been flattened, a stopper film 2 with a slow polishing rate is preferably pre-formed under the silicon oxide film 3. The stopper film will generally be a silicon nitride film, but a polysilicon film or the like may be used instead. The step height D of the silicon oxide film 3 is eliminated by the first and second steps, and a device isolation structure having an embedded section 5 is formed.

For polishing of the silicon oxide film 3, the silicon substrate 1 is placed on the abrasive pad such that the surface to be polished of the silicon oxide film 3 contacts the abrasive pad, and the surface to be polished of the silicon oxide film 3 is polished by the abrasive pad. More specifically, the surface to be polished of the silicon oxide film 3 is pressed against the abrasive pad of a polishing platen, and the silicon oxide film 3 is polished by relative movement between the substrate and abrasive pad while supplying the polishing liquid between the surface to be polished and the abrasive pad.

The CMP polishing liquid may be preferably used in both the first step and second step. Among these, the CMP polishing liquid of the second embodiment is preferably used in the second step. This will make possible both a more satisfactory polishing rate and further reduced scratches, and will allow polishing of surface to be polished with irregularities to a greater degree of flatness.

It will also be possible to accomplish polishing using the same CMP polishing liquid in a single stage, without separation into a first step and second step. In this case as well, it is preferred to use a CMP polishing liquid according to the second embodiment, from the viewpoint of eliminating irregularities and obtaining a flat polished surface.

The polishing apparatus used for polishing is preferably an apparatus comprising, for example, a holder which holds the substrate, a polishing platen on which the abrasive pad is mounted, and means for supplying the polishing liquid to the abrasive pad. Examples of such polishing apparatuses include polishing apparatuses by Ebara Corp. (Model EPO-111), polishing apparatuses by AMAT Corp. (trade name: Mirra3400, Reflexion Polishing Machine) and the like.

Although an abrasive pad has been described as the polishing member, the polishing member is not limited thereto. There are no particular restrictions on the abrasive pad, and a common nonwoven fabric, foamed polyurethane, porous fluorine resin or the like may be used. The abrasive pad is preferably furrowed to allow accumulation of the polishing liquid. The abrasive pad is also preferably one such that the surface tension of the CMP polishing liquid is lower than the critical surface tension of the abrasive pad surface. By using such an abrasive pad, it is possible to homogeneously disperse the CMP polishing liquid on the abrasive pad.

The polishing conditions are not particularly restricted, but the rotational speed of the polishing platen is preferably not higher than 200 min⁻¹ from the viewpoint of preventing fly off of the substrate. The pressure (machining load) on the substrate is preferably not greater than 100 kPa, from the viewpoint of further minimizing increase in scratches on the polished surface. The machining load is more preferably 5-50 kPa, in order to satisfy uniformity of the polishing rate within the surface to be polished, and pattern flatness. During polishing, the polishing liquid is preferably continuously supplied to the abrasive pad with a pump. The amount of polishing liquid supplied is not particularly restricted, but preferably the surface of the abrasive pad is covered by the polishing liquid at all times. Specifically, the polishing liquid is preferably supplied at 0.005-0.40 ml/min per 1 cm² area of the abrasive pad.

Upon completion of polishing, preferably the substrate is thoroughly rinsed in running water and a spin dryer or the like is used to remove the water droplets adhering to the substrate and to dry it. Such treatment allows irregularities on the substrate surface to be eliminated, to obtain a smooth surface across the entire substrate. Also, by repeating the step of forming and polishing a film a prescribed number of times, it is possible to produce a substrate having a desired number of layers.

The substrate obtained in this manner may be used as an electronic component. Specific examples include semiconductor elements; optical glass such as photomask lens prisms; inorganic conductive films such as ITO; integrated optical circuits, optical switching elements and optical waveguides composed of glass and crystalline materials; optical fiber tips; optical single crystals such as scintillators; solid-state laser single crystals; blue laser LED sapphire substrates; semiconductor single crystals such as SiC, GaP and GaAs; magnetic disk glass panels; magnetic heads; and the like.

### Examples

The present invention will now be explained by examples. However, the invention is not limited to these examples.

### [Examples 1-8, Comparative Examples 1-5]

### (Preparation of cerium oxide particles)

Cerium oxide particles were prepared by firing. Specifically, approximately 6 kg of cerium carbonate was placed in an alumina container and fired in air at 800°C for 2 hours, to obtain about 3 kg of a yellowish white fired powder. Phase identification of the fired powder by X-ray diffraction using CuKα-rays as the line source confirmed that it was cerium oxide. The half-width of the diffraction peak for the (111) plane of the cerium oxide crystals, as determined by powder X-ray diffraction pattern, was 0.31°.

A 3 kg portion of the obtained cerium oxide powder was subjected to dry grinding using a jet mill, so as to leave polycrystalline cerium oxide particles composed of multiple crystallites and having grain boundaries. Either or both the grinding time and grinding pressure were adjusted to obtain cerium oxide particles with mean particle sizes of 0.18 µm and 0.20 µm. The mean particle sizes of the cerium oxide particles were measured using an LA-920 (light source: He-Ne laser and W laser) by Horiba, Ltd.

### (Preparation of CMP polishing liquids)

Cerium oxide particles with a mean particle size of 0.18 µm or 0.20 µm were dispersed in water using a dispersing agent, as shown in Tables 1 and 2, to obtain a dispersion. An aqueous solution of a second additive as shown in Tables 1 and 2 was added to each obtained dispersion, and then a first additive was added, to obtain CMP polishing liquids comprising the components in the contents listed in Tables 1 and 2. The dispersing agent content was low enough not to affect the contents of the first and second additives.

A pH meter (Model "PHL-40" by DKK Corp.) was used to measure the pH of each CMP polishing liquid. The pH was measured by placing an electrode in the CMP polishing liquid after 2-point calibration using standard buffer (phthalate pH buffer: pH 4.01 (25°C), neutral phosphate pH buffer: pH 6.86 (25°C)) and measuring the value upon stabilization after an elapse of 2 minutes or more.

### (Preparation of bare wafer and patterned wafer)

A 1000 nm-thick silicon oxide (SiO₂) film was formed on a ϕ200 mm silicon (Si) substrate by plasma-CVD, to obtain a bare wafer having a flat silicon oxide film as a film to be polished.

There was also prepared a patterned wafer having a silicon oxide film with irregularities, as a film to be polished (trade name: SEMATECH864 by Advantech). The patterned wafer was obtained by forming a silicon nitride film as a stopper film on portions of the ϕ200 mm silicon substrate, etching the silicon substrate with 350 nm at the portions without the silicon nitride film to form trench sections, and then forming a 600 nm silicon oxide film by plasma-CVD on the stopper film and in trench sections. The patterned wafer has a pattern with line widths: Line/Spece = 500/500 µm, 100/100 µm.

The CMP polishing liquid was used for polishing of the silicon oxide films of the bare wafer and the patterned wafer. The polished wafers were used for measurement of the number of scratches, the polishing rate and the residual step height after polishing, under the following conditions. The polishing of the substrates and each measurement for Examples 1-6 and Comparative Examples 1-5 were conducted on the same day.

A polishing apparatus (Model EPO111 by Ebara Corp.) was used for polishing of each wafer in the following manner. First, the bare wafer or patterned wafer was set in a holder mounting an adsorption pad for attachment of the substrate. Next, a porous urethane resin abrasive pad (furrow shape: perforated type, model IC1000 by Rohm and Haas) was attached to the ϕ600 mm polishing platen of the polishing apparatus. The holder was situated so that the film to be polished was opposing the abrasive pad. The machining load was set to 34.3 kPa.

Each film to be polished was polished with the abrasive pad by rotating the polishing platen and rotating the bare wafer or patterned wafer for 1 minute at 50 min⁻¹ each while dropping the CMP polishing liquid onto the polishing platen at a rate of 200 ml/min. The polished wafers were thoroughly washed with purified water and dried.

### (Measurement of number of scratches)

Contaminants on the polished bare wafer were detected using a Complus by AMAT, defining 0.2 µm as the detection size for contaminants. Since the detected contaminants include adhered substances in addition to scratches, each contaminant was observed by SEM, the concavities were judged as scratches, and the number of scratches was counted. A ϕ200 mm bare wafer with a dead area of 3000 mm² was used for the measurement. The measurement results for the number of scratches are shown in Tables 1 and 2.

### (Measurement of polishing rate)

An RE-3000 by SCREEN was used to measure the film thickness of the silicon oxide film of the bare wafer before and after polishing, and the polishing rate per minute was calculated. The measurement results for the polishing rate are shown in Tables 1 and 2.

### (Flatness evaluation: Measurement of residual step height after polishing)

The step height remaining after polishing (residual step height after polishing) of the patterned wafer was measured at the sections with Line/Spece = 500/500 µm and 100/100 µm. The results are shown in Tables 1 and 2. In Tables 1 and 2, the step heights at sections of Line/Spece = 500/500 µm are denoted as "Step height 500/500", and the step heights at sections of Line/Spece = 100/100 µm are denoted as "Step height 100/100".

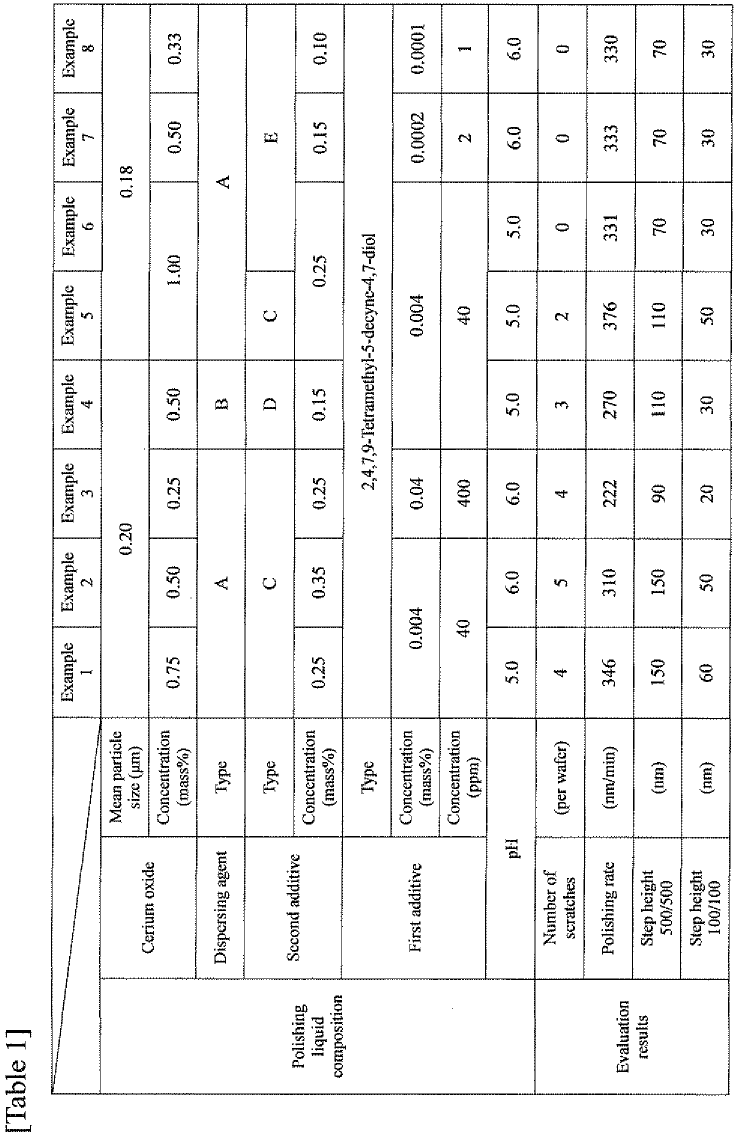

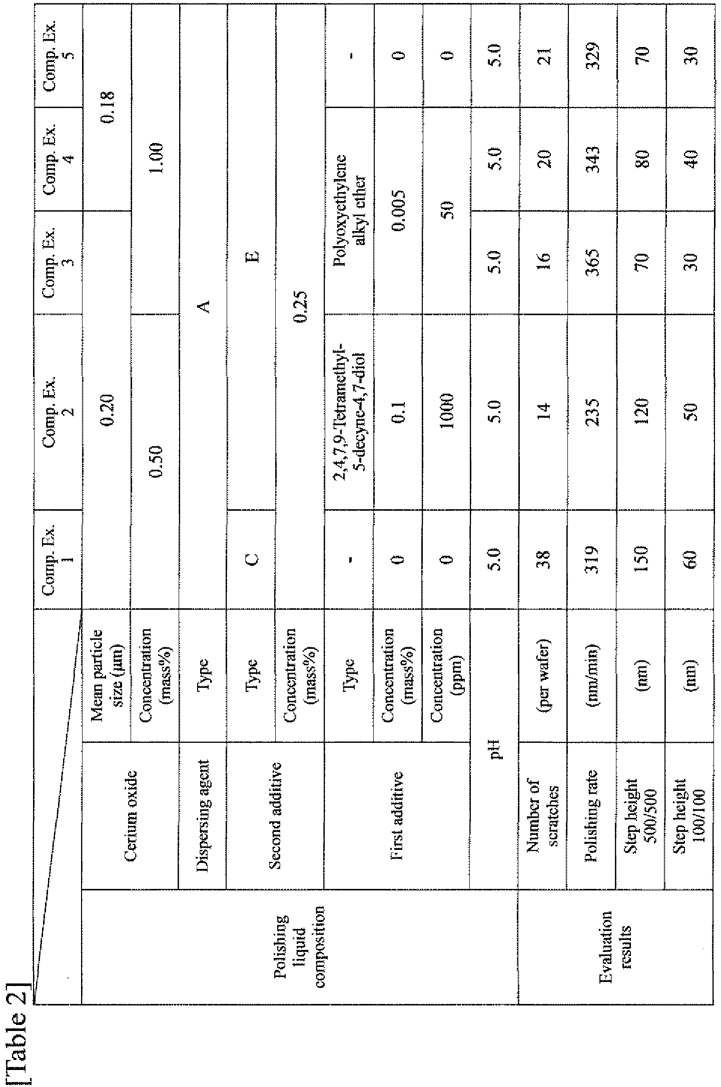

The compounds represented by "A" to "E" for the dispersing agents and additives in Tables 1 and 2 are the following.
A: Ammonium polyacrylate salt with a weight-average molecular weight of 10000, obtained by copolymerization of acrylic acid and methyl acrylate (product name: A6114 by ToaGosei Co., Ltd.).
B, D: Potassium polyacrylate salt with a weight-average molecular weight of 4000, obtained by polymerization of acrylic acid monomer with potassium sulfite as the initiator.
C: Ammonium polyacrylate salt with a weight-average molecular weight of 4000, obtained by polymerization of an acrylic acid monomer with 2,2'-azobisisobutyronitrile as the initiator.
E: Ammonium polyacrylate salt with a weight-average molecular weight of 4000, obtained by polymerization of acrylic acid monomer with ammonium sulfite as the initiator.

The weight-average molecular weight of each compound was determined under the following conditions.

### (Conditions)

Sample: 10 µL
Standard polystyrene: Standard polystyrene by Tosoh Corp. (weight-average molecular weights: 190000, 17900, 9100, 2980, 578, 474, 370, 266)
Detector: RI-monitor by Hitachi, Ltd., trade name: "L-3000"
Integrator: GPC integrator by Hitachi, Ltd., trade name: "D-2200"
Pump: Trade name "L-6000" by Hitachi, Ltd.
Degassing apparatus: Trade name "Shodex DEGAS" by Showa Denko K.K.
Column: Trade names "GL-R440", "GL-R430" and "GL-R420" by Hitachi Chemical Co., Ltd., linked in that order.
Eluent: Tetrahydrofuran (THF)
Measuring temperature: 23°C
Flow rate: 1.75 mL/min
Measuring time: 45 minutes

As shown in Tables 1 and 2, the CMP polishing liquids of Examples 1-8 were confirmed to result in excellent polishing rate and post-polishing surface flatness, as well as a low number of scratches. In contrast, it was confirmed that the number of scratches was increased in Comparative Examples 1-5, compared to Examples 1-8.

### [Examples 9-14, Comparative Examples 6-9]

In Examples 9-14 and Comparative Examples 6-9, the mean particle size of the cerium oxide was fixed at 0.18 µm, and the effect of the concentration of the first additive on the polishing properties was observed. In order to simultaneously confirm the effect of the cerium oxide particle concentration on the polishing properties, the cerium oxide concentration was fixed at 0.50 mass% in Examples 13 and 14, and the cerium oxide concentration was fixed at 1.00 mass% in Examples 9-12 and Comparative Examples 6-9. The second additive, which functions mainly as a flattening agent, was not added.

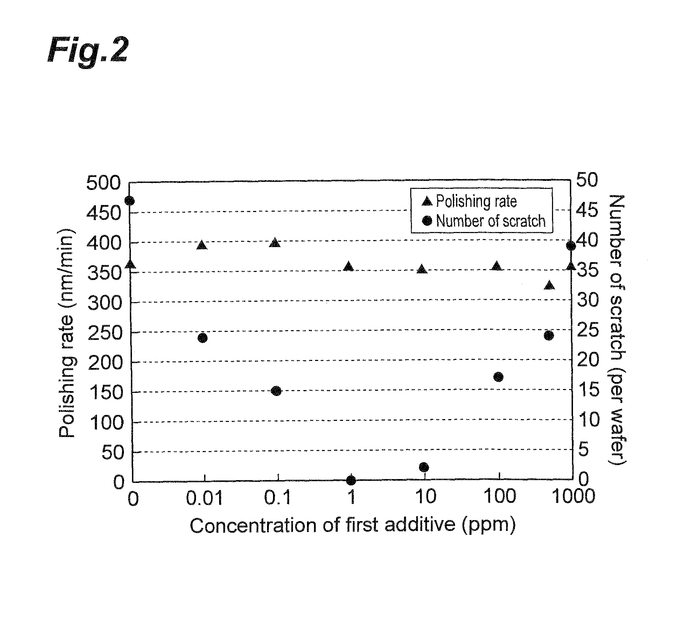

CMP polishing liquids were prepared comprising each of the components in the amounts listed in Table 3, and the number of scratches and polishing rate were measured after polishing bare wafers, in the same manner as Examples 1-8 except that the CMP polishing liquids were obtained by adding aqueous solutions of the first additives listed in Table 3 to the dispersions. The measurements for Examples 9-14 and Comparative Examples 6-9 were conducted on the same day. The measurement results are shown in Table 3. Fig. 2 shows the measurement results for Examples 9-12 and Comparative Examples 6-9. Fig. 2 is a view showing the relationship of first additive concentration to polishing rate and number of scratches. In Fig. 2, the polishing rate is shown on the left axis, and the number of scratches is shown on the right axis.

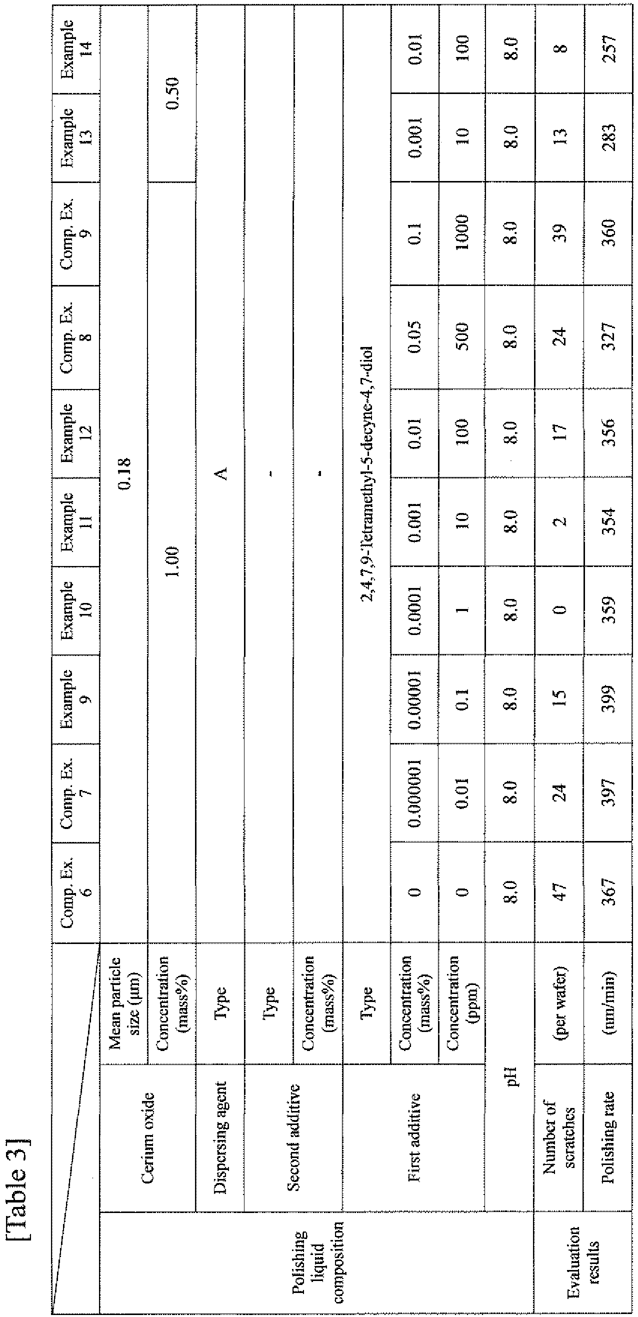

As shown in Table 3, in Examples 9-14, an effect of reducing scratches was confirmed, and maintenance of a high polishing rate was also confirmed. A reduction in scratches was also confirmed even in Examples 13 and 14, which had lower abrasive grain contents than Examples 9-12. On the other hand, an increase in the number of scratches was confirmed in Comparative Examples 6-9.

### [Examples 15-19, Comparative Examples 10-12]

In Examples 15-19 and Comparative Examples 10-12, the effect of the first additive concentration on the polishing properties was observed. CMP polishing liquids were prepared comprising each of the components in the concentrations listed in Table 4, in the same manner as Examples 1-8. Each CMP polishing liquid was used for measurement of the number of scratches and polishing rate of a bare wafer, and for measurement of the residual step height after polishing of a patterned wafer. The measurements for Examples 15-19 and Comparative Examples 10-12 were conducted on the same day. The measurement results are shown in Table 4.

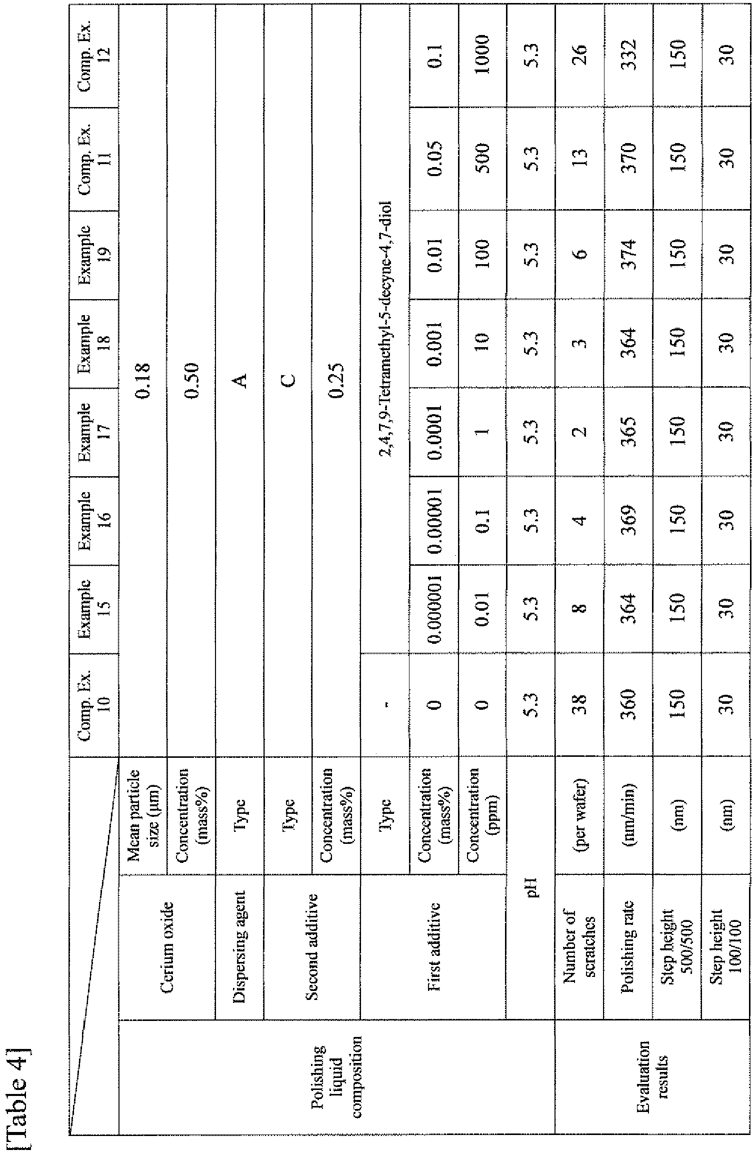

As shown in Table 4, in Examples 15-19, an effect of reducing scratches was confirmed, and maintenance of a high polishing rate was also confirmed. On the other hand, an increase in the number of scratches was confirmed in Comparative Examples 10-12.

### [Examples 20-22]

In Examples 20-22, the effect of the CMP polishing liquid supply method on the polishing properties was observed.

In Example 20, a CMP polishing liquid (one-pack) with the same content as Example 1 was prepared again.

In Example 21, a cerium oxide slurry comprising cerium oxide particles, a dispersing agent and water, and an additive liquid comprising the first additive and second additive, were supplied through separate tubings, mixed in a single tubing just before dropping, and finally prepared into a CMP polishing liquid with the same content as Example 1.

In Example 22, the same cerium oxide slurry and additive liquid as Example 21 were supplied through separate tubings, mixed on an abrasive pad, and finally prepared into a CMP polishing liquid with the same content as Example 1.

Each CMP polishing liquid was used for measurement of the number of scratches and polishing rate of a bare wafer, and for measurement of the residual step height after polishing of a patterned wafer. The measurements for Examples 20-22 were conducted on the same day. The measurement results are shown in Table 5.

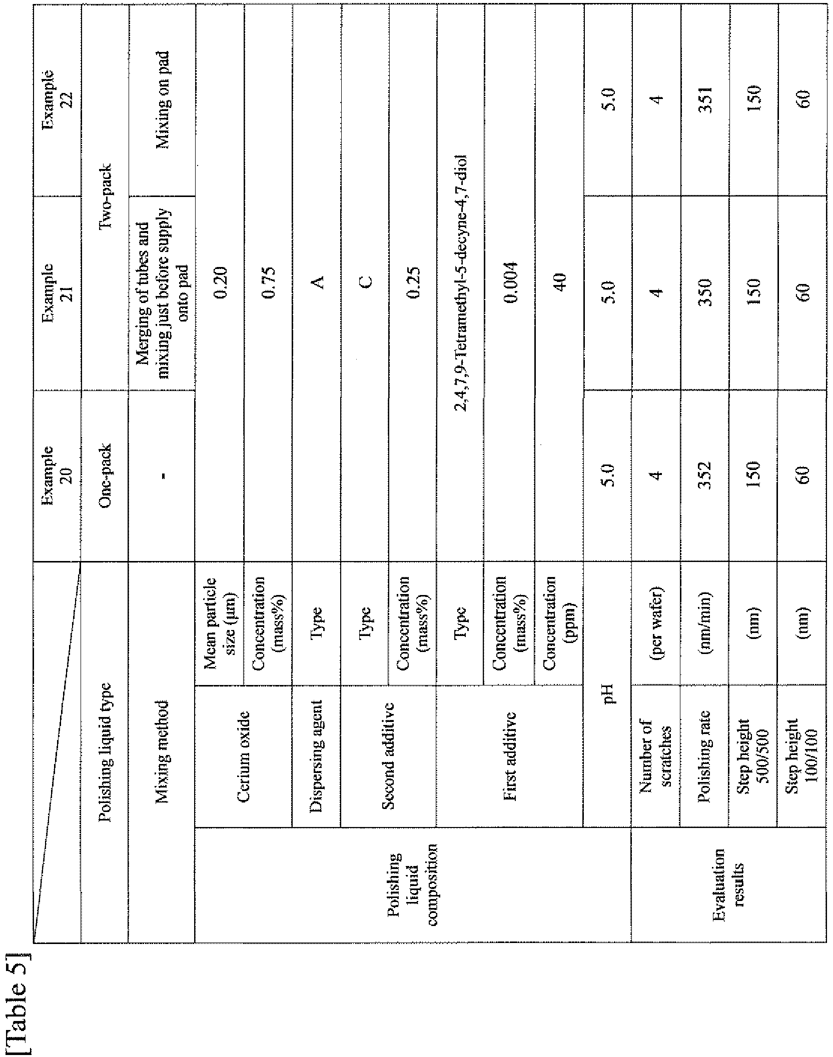

As shown in Table 5, in Examples 20-22, the same effect of reducing scratches was confirmed, and maintenance of a high polishing rate was also confirmed.

### Reference Signs List

1: Silicon substrate (semiconductor substrate), 2: stopper film, 3: silicon oxide film (inorganic insulating film), 5: embedded section, D: Difference of elevation of film thickness of silicon oxide film (step height).

## Claims

1. A CMP polishing liquid comprising cerium oxide particles, an organic compound with an acetylene bond, and water,
a content of the organic compound with an acetylene bond being at least 0.00001 mass% and not greater than 0.01 mass% based on a total mass of the CMP polishing liquid.

2. The CMP polishing liquid according to claim 1, obtained by mixing a first liquid comprising the cerium oxide particles and water, and a second liquid comprising the organic compound with an acetylene bond and water.

3. A CMP polishing liquid comprising cerium oxide particles, an organic compound with an acetylene bond, an anionic polymer compound or salt thereof, and water,
the anionic polymer compound being obtained by polymerizing a composition comprising a vinyl compound with an anionic substituent as a monomer component,
a content of the organic compound with an acetylene bond being at least 0.000001 mass% and less than 0.05 mass% based on a total mass of the CMP polishing liquid.

4. The CMP polishing liquid according to claim 3, obtained by mixing a third liquid comprising the cerium oxide particles and water, and a fourth liquid comprising the organic compound with an acetylene bond, the anionic polymer compound or salt thereof, and water.

5. The CMP polishing liquid according to claim 3 or 4, wherein the vinyl compound with an anionic substituent is at least one type selected from acrylic acid and methacrylic acid.

6. The CMP polishing liquid according to any one of claims 3 to 5, wherein a content of the anionic polymer compound or salt thereof is greater than the content of the organic compound with an acetylene bond.

7. The CMP polishing liquid according to any one of claims 3 to 6, wherein a content of the anionic polymer compound or salt thereof is 0.01-2.00 mass% based on a total mass of the CMP polishing liquid.

8. The CMP polishing liquid according to any one of claims 1 to 7, wherein the organic compound with an acetylene bond is an acetylene glycol.

9. The CMP polishing liquid according to claim 8, wherein the acetylene glycol is a compound represented by the following formula (1). 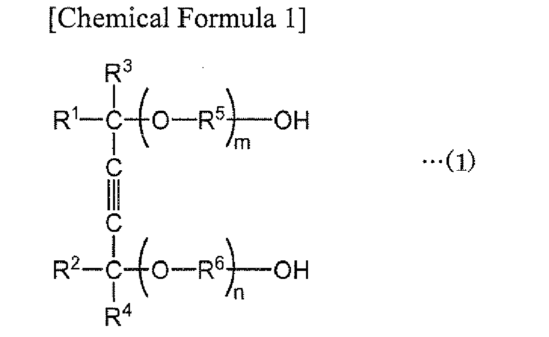 (In formula (1), R¹-R⁴ each independently represents a hydrogen atom or a C1-C5 substituted or unsubstituted alkyl group, R⁵ and R⁶ each independently represents a C1-C5 substituted or unsubstituted alkylene group, and m and n each independently represents 0 or an integer.)

10. The CMP polishing liquid according to claim 8 or 9, wherein the acetylene glycol is 2,4,7,9-tetramethyl-5-decyne-4,7-diol.

11. A polishing method comprising a step of polishing a film to be polished, that has been formed on a base substrate, using the CMP polishing liquid according to any one of claims 1 to 10.

12. A semiconductor substrate manufacturing method comprising a step of polishing an inorganic insulating film that has been formed on a semiconductor substrate, using the CMP polishing liquid according to any one of claims 1 to 10.
